# EUROPEAN PATENT APPLICATION

(11) **EP 2 128 699 A1**
(43) Date of publication of application: **02.12.2009**
(21) Application number: 08075520.0
(22) Date of filing: 28.05.2008
(51) Int. Cl.: G03F 1/00, G03F 7/12

(54) **Base material for preparing a stencil for screen printing**

(71) Applicant: Stork Prints B.V., 5831 AT Boxmeer (NL)
(72) Inventor: Everaars, Marcel Dialma, 5985 PX Grashoek (NL); Koetsier, Arnold Anthony, 6932 JS Westervoort (NL)
(74) Representative: Volmer, Johannes Cornelis

(57) **Abstract**

The invention relates to a base material (10)for preparing a stencil (30) for screen printing, wherein the base material (10) comprises a screen (12) comprising a network of dykes (20) delimiting openings (22), a photoresist material covering at least one side of the screen (12) as a layer (14) , a levelling film (16) contacting the photoresist material at said side, and a mask layer (18) on top of the levelling film (16), the mask layer (18) comprising a laser ablatable material that is opaque to the light used for exposing the photoresist material.

## Description

The invention relates to screen printing, more particularly to a base material for preparing a stencil for screen printing, stencil preparation methods, a method for the production of the base material, a kit of parts and use thereof.

DE 42 43 750 A1 discloses a method of manufacturing a printing forme for intaglio printing, screen printing, flexography or offset printing. In this method a surface of the printing forme is provided with a first layer of a light sensitive photopolymer and on top thereof a second layer of a sensitive material having a different type of light sensitivity or a higher sensitivity than the photopolymer. This second layer is exposed to radiation, e.g. laser radiation, controlled by data representing an image to be printed. The radiation exposed areas are removed (ablated), thereby forming a photomask, through which the first layer of photosensitive material is exposed and developed. For screen printing the printing forme comprises a sieve material and a stencil having open areas defining the image to be printed will be obtained in this way.

EP 0 913 730 A1 discloses also a method of manufacturing a printing forme, e.g. for flexography or screen printing. A first layer of a light sensitive material carried on a support is covered by a cover layer, which is patterned, e.g. partially removed using a laser, in order to obtain a mask, through which the first layer is exposed and subsequently developed. In this way, a stencil defining the image to be printed by screen printing is obtained if the support is a screen.

Now it has appeared that the printing quality of the products printed using a stencil as described above, leaves something to be desired, in particular the resolution is reduced compared to a stencil produced in accordance with the common state of the art technology, wherein the mask is a film carrying a negative or positive of the image to be printed, which is produced using (wet) photochemistry of silver halides. This kind of photochemistry is however laborious, time-consuming and questioned in view of environmental considerations.

Furthermore the material from which the mask layer is made, should be removable together with the photoresist after exposure of the latter using the same washing solution. This provides a limitation to the selection of materials that can be used in the second or cover layer, from which the mask is made.

Thus there is a need for stencil production methods and starting materials, which do not show the drawbacks discussed above, in particular allowing offering a good printing resolution.

According to the invention this need is fulfilled by a base material for preparing a stencil for screen printing, wherein the base material comprises a screen comprising a network of dykes delimiting openings, a photoresist material covering at least one side of the screen as a layer, a transparent levelling film contacting the photoresist material at said side, and a mask layer on top of the levelling film, the mask layer comprising a laser ablatable material that is opaque to the light used for exposing the photoresist material.

The starting material for producing a stencil for screen printing according to the invention comprises a screen. The screen comprises a network of dykes, usually in a regular pattern. These dykes delimit openings having in cross-section e.g. a round, oval or polygonal shape such as square or hexagonal. A photoresist material is present at least on one side of the screen covering the respective dykes. This side will be the printing surface of the stencil during printing opposite to the squeegee or doctor blade side. Usually the photoresist material is also present in the openings of the screen itself. The photoresist layer is provided with a levelling film. This levelling film is transparent for the actinic (inducing a photochemical reaction in the photoresist) radiation used for exposing the photoresist. The levelling film is releasably adhered to the photoresist material, e.g. the levelling film can be peeled off manually. On its turn the outer surface of the levelling film carries a mask layer. This mask layer comprises a material that can be removed by high energy radiation, e.g. ablated by a laser, while the irradiation of the mask layer using a laser does not affect the underlying photoresist.

It has been found by the present inventors that deterioration of the printing quality of the printed products obtained using a stencil that has been made in accordance with prior art procedures as described above, is due to an interaction between the photoresist material and the mask material. This interaction may occur e.g. during production and storage of the base material and prior to the actual use thereof. As a result of this interaction the surface of the photoresist material that ought to be as flat as possible, shows irregularities. During printing these irregularities cause printing ink or printing paste flowing from open printing openings defining the image to be printed over the adjacent photoresist (also known as "broadening") before the ink or paste is applied to the substrate to be printed instead of flowing directly from the open printing openings to the substrate to be printed. This phenomenon is considered to be responsible for the reduction of the resolution, as a result of which the images printed are less sharp than desired.

In the base material according to the invention a levelling film prevents the direct contact of the photoresist layer and the mask layer with each other. Thus interaction of the photoresist and the mask material is not possible in the base material. Thus the levelling film maintains the flatness of the photoresist surface. Consequently a high resolution image can be printed using a stencil obtained from the base material according to the invention. Due to the separation between the photoresist material and the mask material by means of the levelling film the mask material need not to be washable, such as soluble in water like the photoresist material. Thus the invention allows selecting a suitable masking material from a large group of masking materials. Usually the assembly of levelling film and imaged mask layer will be removed together and can be stored. If at a later time a repeat order is obtained by the printer, then the printing job can be carried out easily and quickly using the stored assembly without the need to manufacture an imaged mask layer again. In a base material according to the prior art the patterned mask layer is destroyed upon exposure and removal of the photoresist material.

Here it is to be noted that a base material for screen printing comprising a screen, a resist material and a protective film on top of the resist material and production methods thereof are known from WO 2005/091075 A2 and WO 2006/025739 A1. These methods aim at providing a high and uniform filling level of resist material in the openings of the screen.

In the context of this application the term "stencil" refers to a screen having a network of interconnected dykes, which delimit a number of openings. A part of the openings is (partially) covered or filled with photoresist. The remaining openings are (partially) open and define the image to be printed.

In this application the term "mask layer" refers to a layer of a substance that can be removed (ablated) using a laser in order to obtain a mask. This substance is opaque to the radiation of light used for exposure of the photoresist.

Both positive resist and negative resist can be used as photoresist material in the invention using actinic light. A positive resist is a type of photoresist in which the portion of the photoresist that is exposed to light becomes soluble to the photoresist developer and the portion of the photoresist that is unexposed remains insoluble to the photoresist developer. If a negative resist (most commonly employed) is used, the exposed portion becomes relatively insoluble to the photoresist developer. The unexposed portion is dissolved by the photoresist developer. Generally the photoresist materials are exposed to light having a wavelength in the ultraviolet spectrum or shorter (< 400 nm).

In addition to the documents referred to above, suitable masking materials are also known in the art of flexography, e.g. from US-A-5262275 and US-A-6238837 . Advantageously, the masking material comprises a particulate material in a binder. In a preferred embodiment the particulate material comprises carbon black. Preferably, the mask layer has a thickness of less than 10 micrometers, preferably less than 5 micrometer. In this case the mask layer can be ablated e.g. using a Nd-YAG laser, which shows a high resolution compared to other laser types such as a CO2 laser at the same power.

In a further preferred embodiment the levelling film has a thickness of less than 25 micrometers, in particular less than 15 micrometers. Once the mask layer has been provided with the image as desired, a levelling film that is transparent to the actinic radiation and having such a thickness allows to expose the photoresist directly without causing undue scattering of light. If a levelling film having a larger thickness is present, scattering is more likely to occur resulting in a reduced edge sharpness.

In another preferred embodiment the levelling film has a thickness greater than 80 micrometers, in particular in the range of 100-200 micrometers, such as e.g. 150 micrometers. A levelling film of this kind can be handled more easily, which is beneficial in manufacturing the base material for screen printing according to the invention. In order to reduce scattering using a levelling film of this kind, after laser ablation of the mask layer in order to prepare a suitable mask, the levelling film having such a mask is released from the photoresist layer supported by the screen material, then turned upside down and again positioned on the photoresist layer. Because the mask is positioned directly on top of the photoresist layer scattering is reduced.

The screen material of the base material according to the invention can be selected from the conventional screen printing material, such as porous fabric (silk, plastic) and metallic sieves. Preferably, the screen material is an electroformed metal screen, i.e. made by electroforming using a die in an electrolytic bath containing a metal such as nickel.

Advantageously, the base material has a coiled shape, because it is made in a continuous "roll-to-roll" process. Upon use a piece of base material is cut at appropriate dimensions and then processed into a stencil, whether for flat screen printing or rotary screen printing.

According to a second aspect the invention relates to a method of manufacturing a base material according to the invention, comprising the steps of:
1) providing a screen comprising a network of dykes delimiting openings,
2) applying a photoresist material onto one side of the screen as a layer,
3) providing a levelling film on said photoresist material, and
4) applying a mask layer on top of the levelling film.

In this manufacturing method according to the invention a conventional screen material is provided with a photoresist material. In view of a uniform level of filling and flatness advantageously the photoresist material is coated as disclosed in WO 2006/025739 A1. Then the levelling film is releasably adhered to the thus prepared subassembly of screen and photoresist material. Next the masking material is coated on the levelling film, e.g. using a squeegee.

In a preferred embodiment the levelling film is provided with the mask layer prior to the application of the levelling film to the photoresist layer. In other words, the above steps 3) and 4) are performed by coating the levelling film with the mask layer thereby obtaining a subassembly of the levelling film and the mask layer and then applying the subassembly to the photoresist material such that the levelling film contacts the photoresist material. Because of the sensitivity to normal light (especially the UV spectrum) of the photoresist material, the application of the photoresist material onto the screen material should be carried out under special light conditions avoiding the exposure to normal light. In this preferred embodiment the mask layer can be applied to the levelling film under conventional conditions without the need of a specially conditioned facility with respect to light. Thus the production of the base material can be performed at reduced costs. A further advantage is that quality control of the coating thickness of the mask layer on the levelling film is more easy, e.g. by measuring its optical density. This quality control is difficult to carry out with the final base material. It will be appreciated that in this preferred embodiment the considerations about the levelling film thickness in view of handling play also an important role.

According to a further aspect the invention relates to manufacturing a stencil for screen printing from a base material. As already explained above the base material, if the levelling film is sufficiently thin, the photoresist material can be exposed directly to actinic radiation through the mask layer that is provided with an image by ablation using a laser and through the levelling film. Such a method of manufacturing a stencil for screen printing from a base material comprises the steps of:
a) providing a base material for screen printing according to the invention,
b) removing laser ablatable material from the mask layer according to a predefined image using laser radiation thereby obtaining an imaged mask layer
c) exposing the photoresist material through the imaged mask layer
d) removing the assembly of levelling film and imaged mask layer, and
e1) if the photoresist is a positive resist, removing the exposed photoresist material, thereby obtaining a stencil for screen printing defining the image to be printed using the stencil, or
e2) if the photoresist is a negative resist, removing the non-exposed photoresist material, thereby obtaining a stencil for screen printing defining the image to be printed using the stencil.

A stencil preparation method that is preferred for relatively thick levelling films further comprises a step f) between steps b) and c) of removing the assembly of levelling film and imaged mask layer, turning the assembly upside down and positioning the assembly thus turned on the photoresist material layer. In this embodiment during exposure of the photoresist the imaged mask layer contacts the photoresist material layer. Therefore the thickness of the levelling film being on top of the imaged mask layer has no detrimental effect on the sharpness of the photoresist material exposed.

Advantageously the base material is cut to the appropriate dimensions and provided with registration holes e.g. by punching prior to step b. These registration holes are used for positioning the stencil once prepared in a suitable frame for flat screen printing or into suitable end rings for rotary screen printing. The frame or end rings are generally provided with matching pens. In addition these holes allow to positioning the subassembly of levelling film and imaged mask layer as it has been turned, with respect to the subassembly of screen and photoresist to be exposed.

According to a further aspect the invention also relates to a kit of parts comprising a first subassembly of a screen comprising a network of dykes delimiting openings and a photoresist material covering at least one side of the screen and a second subassembly of a levelling film provided with a mask layer comprising a laser ablatable material that is opaque to the light used for exposing the photoresist material. This kit of parts allows to have the mask layer being imaged using laser ablation prior to the positioning thereof onto the first assembly. An advantage of this kit of parts is that if the imaged mask layer does not meet the requirements, e.g. incorrect position of image sections, only the imaged mask layer and the corresponding levelling film have to be disposed off, while the more expensive first subassembly comprising the (metal) screen still can be used. Preferably at least one of the subassemblies has a coiled shape, more preferably both subassemblies are in a coiled shape.

Advantageouly a method of manufacturing a stencil for screen printing from a base material from such a kit of parts comprises the steps of:
providing a first subassembly of a screen comprising a network of dykes delimiting openings and a photoresist material covering at least one side of the screen
providing a second subassembly of a levelling film provided with a mask layer,
removing the laser ablatable material according to a predefined image using laser radiation thereby obtaining an imaged mask layer
positioning the assembly of levelling film provided with the imaged mask layer onto the photoresist material layer
exposing the photoresist material through the imaged mask layer
removing the assembly of levelling film and imaged mask layer and
if the photoresist is a positive resist, removing the exposed photoresist material, thereby obtaining a stencil for screen printing defining the image to be printed using the stencil, or
if the photoresist is a negative resist, removing the non-exposed photoresist material, thereby obtaining a stencil for screen printing defining the image to be printed using the stencil.

The invention will be illustrated in view of the attached drawings, wherein
Fig. 1 shows an embodiment of a base material according to the invention;
Fig. 2 shows a first embodiment of a method of preparing a stencil using the base material of fig. 1;
Fig. 3 shows a second embodiment of a method of preparing a stencil using a base material according to the invention; and
Fig. 4 shows an embodiment of manufacturing a base material according to the invention.

In these figs. identical elements are indicated by the same reference numerals.

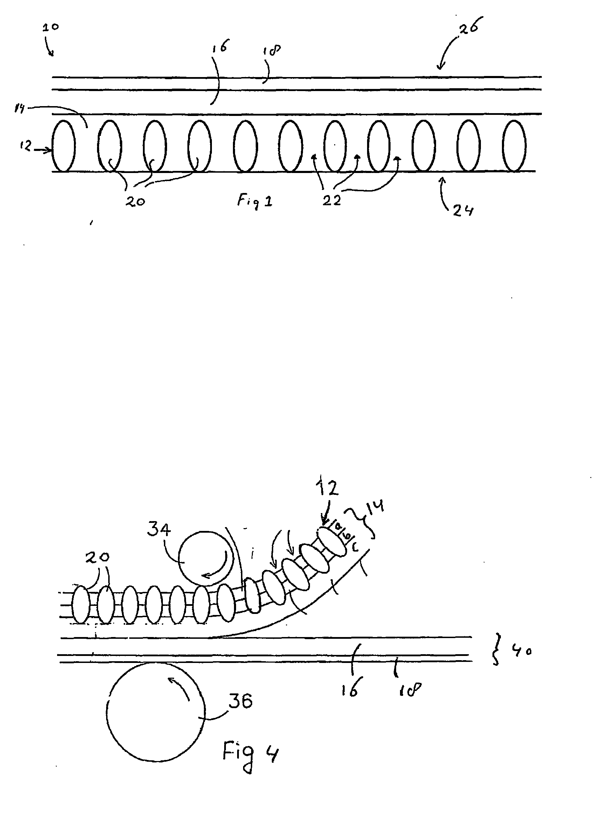

Fig. 1 is a diagrammatical cross-section of an embodiment of a base material according to the invention. Here it is noted that the figures are not drawn to scale. The base material as a whole is identified by reference numeral 10. The base material 10 comprises an electroformed nickel screen 12 having a thickness of e.g. 80-120 micrometer, a photoresist layer 14, a levelling film 16 and a mask layer 18 advantageously having a thickness of less than 10 micrometer e.g. 4 micrometer. The screen 12 is composed of a network of interconnected dykes 20. Generally the network will have a regular pattern. The upstanding walls of the dykes 20 delimit openings 22. The openings 22 are uniformly filled with a photoresist defining the photoresist layer 14. This layer 14 fills the openings 22 from the squeegee side 24 of the base material 10 to the printing side 26. At this printing side 26 the photoresist layer 14 extends slightly above the top of the screen 12, e.g. by 4 micrometers. Upon the photoresist layer 14 the transparent levelling film 16 made e.g. from poly ethylene is present. At the surface thereof opposite the photoresist layer 14 the mask layer 18 e.g. comprising carbon black as UV absorber in a binder is provided.

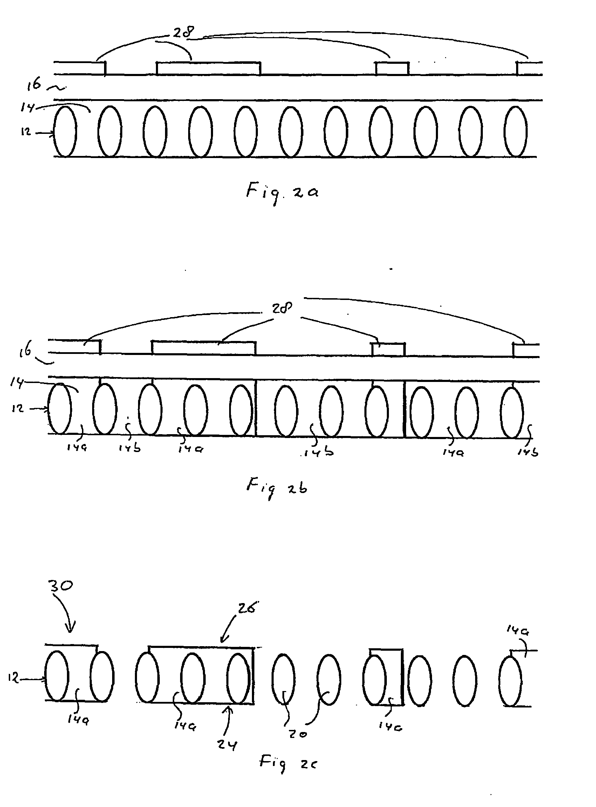

Fig. 2 shows an embodiment of a process for preparing a screen printing stencil starting from the base material 10 shown in fig. 1. It is assumed that the levelling film 16 has a relatively small thickness e.g. less than 15 micrometers, such as 10 micrometers allowing direct exposure of the photoresist of the photoresist layer 14, after imaging the mask layer 18. In a first step the masking material of the mask layer 18 is irradiated by a Nd-YAG laser in those areas where the masking material is to be ablated. The laser movement over the base material 10 is controlled e.g. by a computer having a memory, wherein data about these areas are stored. As a result the mask layer 18 is processed into a mask or imaged mask layer indicated by reference numeral 28. The mask 28 defines an image (removed areas) to be reproduced in the photoresist layer 14. See fig. 2a. Next the photoresist material of the photoresist layer 14 is exposed to UV light through the mask 28 and levelling film 16. In this case a positive photoresist is used, which becomes soluble upon exposure. The interface between the non-exposed areas (14a) of the photoresist layer 14 and the exposed areas (14b) thereof are indicated by solid lines. See fig. 2b. Then the levelling film 16 carrying the mask 28 is peeled from the photoresist layer 14, and the assembly of screen 12 and photoresist layer 14 thus treated is washed in a suitable developer solution for the photoresist, thereby removing the areas of photoresist material that had become soluble. As a result a stencil 30 is obtained. See fig. 2c. The stencil 30 comprises the screen 12, of which a number of openings 22 no longer contain or only contain partially the photoresist material of the original photoresist layer 14. The stencil 30 thus prepared can be tightened in a frame or end rings in a conventional manner. As the surface roughness of the photoresist layer 14 at the printing side 26 is small due to the use of the levelling film 16 between the photoresist layer 14 and the mask layer 18 the risk of broadening of the image printed on a substrate is small.

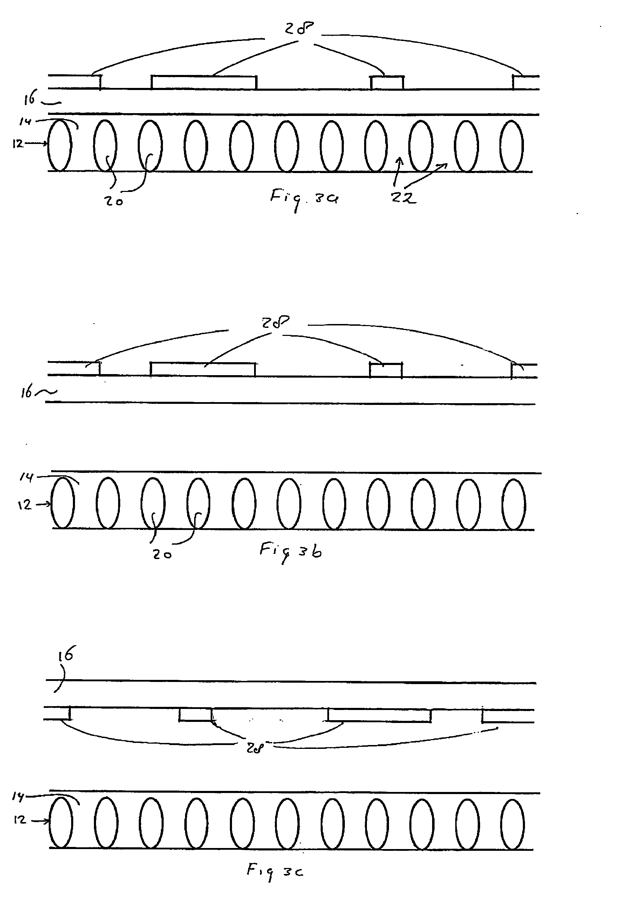

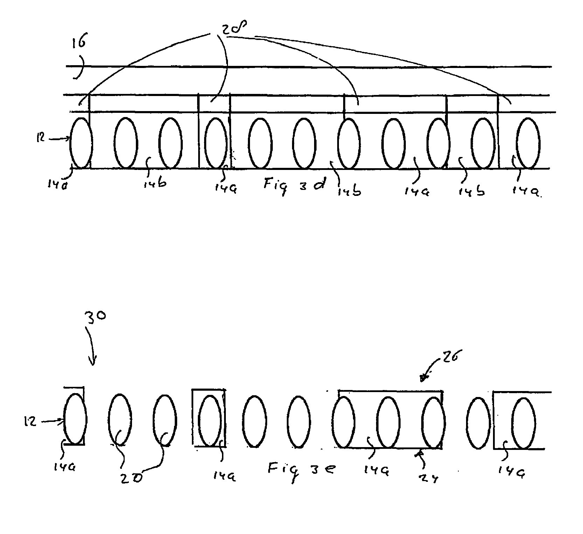

Fig. 3 shows another embodiment of a method according to the invention of preparing a stencil 30. In this case the levelling film 16 has a thickness of about 150 micrometers. Similar to the process illustrated in fig. 2 in a first step the mask layer 18 is processed into a mask 28 using a computer controlled laser (not shown).See fig. 3a. In a next step the levelling film 16 carrying the mask 28 is released from the photoresist layer 14 (see fig. 3b) and reversed (see fig. 3c), such that upon re-application the mask 28 contacts the photoresist layer 14 and the levelling film 16 is the uppermost layer. Of course this turning movement of the mask 28 is taking into account in directing the laser movement over the mask layer 18 generating the mask 28. Subsequently the photoresist material (again a positive one is shown) is exposed to UV light through the levelling film 16 and open areas of the mask 28. See fig. 3d. The stencil 30 ready for use as described above is obtained - see fig. 3e - upon releasing the mask 28 and levelling film 16. As during exposure of the photoresist material to UV light to initiate the appropriate photochemical reaction in the exposed areas, the mask 28 is directly in contact with the photoresist layer, scattering of light in the levelling film is avoided as much as possible.
Fig. 4 illustrates an embodiment of a preferred process of manufacturing a base material 10. Firstly, the screen 12 is provided from one side with the photoresist layer 14. The screen 12 is wound from a reel (not shown). The layer 14 may have been applied in a series of sublayers (in this particular embodiment indicated by a, b, c) in plural steps using a squeegee coater. A subassembly 40 of a levelling film 16 having a mask layer 18 has been prepared in advance and is also wound from a reel (also not shown). This subassembly is applied under slight pressure to the outer surface of the photoresist layer 14, preferably while this surface is still wet, such that the levelling film 16 contacts the photoresist layer 14. Pressure is applied by roll 34 and a counterpressure roll 36. Then the thus prepared base material 10 can be wound again on a reel (not shown) for storage. In such a situation, advantageously a separating web is positioned over the mask layer 18.

## Claims

1. Base material (10) for preparing a stencil (30) for screen printing, wherein the base material comprises a screen (12) comprising a network of dykes (20) delimiting openings (22), a photoresist material covering at least one side of the screen as a layer (14), a levelling film (16) contacting the photoresist material at said side, and a mask layer (18) on top of the levelling film, the mask layer (18) comprising a laser ablatable material that is opaque to the light used for exposing the photoresist material.

2. Base material according to claim 1, wherein the laser ablatable material comprises a particulate material in a binding agent.

3. Base material according to claim 2, wherein the particulate material comprises carbon black.

4. Base material according to one of the preceding claims, wherein the mask layer (18) has a thickness of less than 10 micrometers, preferably less than 5 micrometer.

5. Base material according to one of the preceding claims, wherein the screen (12) is an electroformed metal screen.

6. Base material according to one of the preceding claims, wherein the levelling film (16) has a thickness greater than 80 micrometers, preferably in the range of 100-200 micrometer.

7. Base material according to one of the preceding claims, wherein the levelling film (16) has a thickness of less than 25 micrometers, preferably less than 15 micrometers.

8. Base material according to one of the preceding claims, wherein the base material (10) has a coiled shape.

9. Method of manufacturing a base material (10) according to one of the preceding claims, comprising the steps of:
1) providing a screen (12) comprising a network of dykes (20) delimiting openings (22),
2) applying a photoresist material onto one side of the screen as a layer (14),
3) providing a levelling film (16)on said photoresist material, and
4) applying a mask layer (18) on top of the levelling film.

10. Method according to claim 9, wherein steps 3) and 4) are performed by coating the levelling film (16) with the mask layer (18) thereby obtaining a subassembly (40) of the levelling film and the mask layer and then applying the subassembly (40) to the photoresist material such that the levelling film (16) contacts the photoresist material.

11. Method of manufacturing a stencil (30) for screen printing from a base material (10), comprising the steps of:
a) providing a base material (10) for screen printing according to one of the preceding claims 1-8,
b) removing the laser ablatable material according to a predefined image using laser radiation thereby obtaining an imaged mask layer (28)
c) exposing the photoresist material through the imaged mask layer (28)
d) removing the assembly of levelling film (16) and imaged mask layer (28), and
e1) if the photoresist is a positive resist, removing the exposed photoresist material, thereby obtaining a stencil (30) for screen printing defining the image to be printed, or
e2) if the photoresist is a negative resist, removing the non-exposed photoresist material, thereby obtaining a stencil (30) for screen printing defining the image to be printed.

12. Method according to claim 11, further comprising a step f) between step b) and c) of removing the assembly of levelling film (16) and imaged mask layer (28), turning the assembly upside down and positioning the assembly thus turned on the photoresist material layer (14).

13. Kit of parts comprising a first subassembly of a screen (12) comprising a network of dykes (20) delimiting openings (22) and a photoresist material covering at least one side of the screen as a layer (14) and a second subassembly of a levelling film (16) provided with a mask layer (18) comprising a laser ablatable material that is opaque to the light used for exposing the photoresist material.

14. Kit of parts according to claim.13, wherein the first subassembly has a coiled shape.

15. Kit of parts according to one of the preceding claims 13 and 14, wherein the second subassembly has a coiled shape.

16. Method of manufacturing a stencil (30) for screen printing, comprising the steps of:
providing a first subassembly of a screen (12) comprising a network of dykes (20) delimiting openings (22) and a photoresist material covering at least one side of the screen (12) as a layer;
providing a second subassembly of a levelling film (16) provided with a mask layer (18), removing the laser ablatable material according to a predefined image using laser radiation thereby obtaining an imaged mask layer (28),
positioning the assembly of levelling film (16) provided with the imaged mask layer (28) onto the photoresist material layer (14) of the first assembly
exposing the photoresist material through the imaged mask layer (28)
removing the assembly of levelling film (16) and imaged mask layer (28) and
if the photoresist is a positive resist, removing the exposed photoresist material, thereby obtaining a stencil (30) for screen printing defining the image to be printed, or
if the photoresist is a negative resist, removing the non-exposed photoresist material, thereby obtaining a stencil (30) for screen printing defining the image to be printed.
